# EUROPÄISCHE PATENTSCHRIFT

(11) **EP 0 447 615 B1**
(45) Veröffentlichungstag und Bekanntmachung des Hinweises auf die Patenterteilung: **08.02.1995**
(21) Anmeldenummer: 90121067.4
(22) Anmeldetag: 02.11.1990
(51) Int. Cl.: G01R 11/24

(54) **Einrichtung zur Ueberwachung von Apparategehäusen**
Appliance for monitoring housings of apparatus
Dispositif pour surveiller des boîtiers d'appareil

(30) Priorität: 19.03.1990 CH 895/90
(43) Veröffentlichungstag der Anmeldung: 25.09.1991
(73) Patentinhaber: Landis & Gyr Technology Innovation AG, 6301 Zug (CH)
(72) Erfinder: Thiébaud, Michel, CH-6332 Hagendorn (CH); Combémorel, Michel, F-03100 Montluçon (FR); Horvath, Georges, F-03410 Domerat (FR)
(74) Vertreter: Müller, Hans-Jürgen, Dipl.-Ing.

(56) Entgegenhaltungen:
- EP-A- 0 035 323
- DE-A- 2 535 466
- GB-A- 2 196 056
- US-A- 4 337 466

## Beschreibung

Die Erfindung bezieht sich auf eine Einrichtung zur Überwachung von Apparategehäusen der im Oberbegriff des Anspruchs 1 genannten Art.

Es ist bekannt, daß die Verschlußeinrichtung von vielen und insbesondere von solchen Apparategehäusen plombiert ist, die der Messung und Verrechnung von Energie dienen. Ein solches Apparategehäuse kann nur dadurch geöffnet werden, daß zuerst die Plomben aufgebrochen werden. Durch das Kontrollieren der Plomben kann jederzeit festgestellt werden, ob unberechtigterweise das Apparategehäuse geöffnet wurde. Apparate, wie beispielsweise Elektrizitätszähler, deren Zählerstand periodisch abgelesen werden muß, werden bei einer solchen Ablesung auch auf Unversehrtheit der Plomben kontrolliert. Anstelle von Plomben sind auch andere Mittel, wie beispielsweise Vorhängeschlösser oder Sicherungslacke, in Gebrauch, um ein unbefugtes Öffnen von Apparategehäusen zu erkennen. Ein Problem tritt bei Geräten auf, die nicht regelmäßig kontrolliert werden, wie beispielsweise Elektrizitätszähler, die zur Fernablesung eingerichtet sind. Wird das Gehäuse oder der Klemmendeckel eines solchen Elektrizitätszählers unberechtigterweise geöffnet und werden dabei in betrügerische Absicht Veränderungen am Elektrizitätszähler vorgenommen, so kann dies lange Zeit unbemerkt bleiben und der Schaden für das Energieversorgungsunternehmen kann entsprechend groß werden.

Es ist auch eine Einrichtung der im Oberbegriff des Anspruchs 1 genannten Art bekannt (EP-A-0 035 323), die einen Sensor mit einem Draht oder einem Lichtleiter aufweist, der durch eine Befestigungsschraube eines Gehäuses geführt ist und beim Öffnen des Gehäuses zerstört wird. Durch diese Zerstörung wechselt ein Zustands-Relais des Sensors seinen Zustand, wobei ein Alarm-Signal ausgelöst wird, welches auch an externe Stellen übertragen werden kann. Die Einrichtung arbeitet nur dann, wenn die Netzspannung vorhanden ist. Bei Ausfall der Netzspannung könnte unberechtigterweise manipuliert werden, ohne daß dies nach Wiederkehr der Netzspannung auffällt, wenn bis dahin wieder plombiert wurde.

Schließlich ist es bekannt (DE-A- 25 35 466), das Gehäuse eines Elektrizitätszählers mit abtastbaren und löschbaren magnetischen Konstrollmarken zu versehen, um mißbräuchliche Beeinflussungen nachzuweisen.

Der Erfindung liegt die Aufgabe zugrunde, eine Einrichtung der im Oberbegriff des Anspruchs 1 genannten Art zu schaffen, die von einer Fernableseeinrichtung noch sicherer überprüfbar ist. Es ist erwünscht, ein Öffnen des Apparategehäuses auch dann festzustellen, wenn dies während eines Netzspannungsausfalls geschehen ist.

Die Erfindung benutzt die im Kennzeichen des Anspruchs 1 angegebenen Merkmale. Vorteilhafte Ausgestaltungen ergeben sich aus den Unteransprüchen.

Nachfolgend werden Ausführungsbeispiele der Erfindung anhand der Zeichnungen näher erläutert.

Es zeigen:
- Fig. 1: ein Apparategehäuse mit einer Verschlusseinrichtung und einem Sensor zur Ueberwachung der Verschlusseinrichtung,
- Fig. 2: einen Sensor zur Ueberwachung der Verschlusseinrichtung,
- Fig. 3: einen Schreib/Lesekopf,
- Fig. 4: einen weiteren Sensor und
- Fig. 5: ein Schema zur Signalauswertung

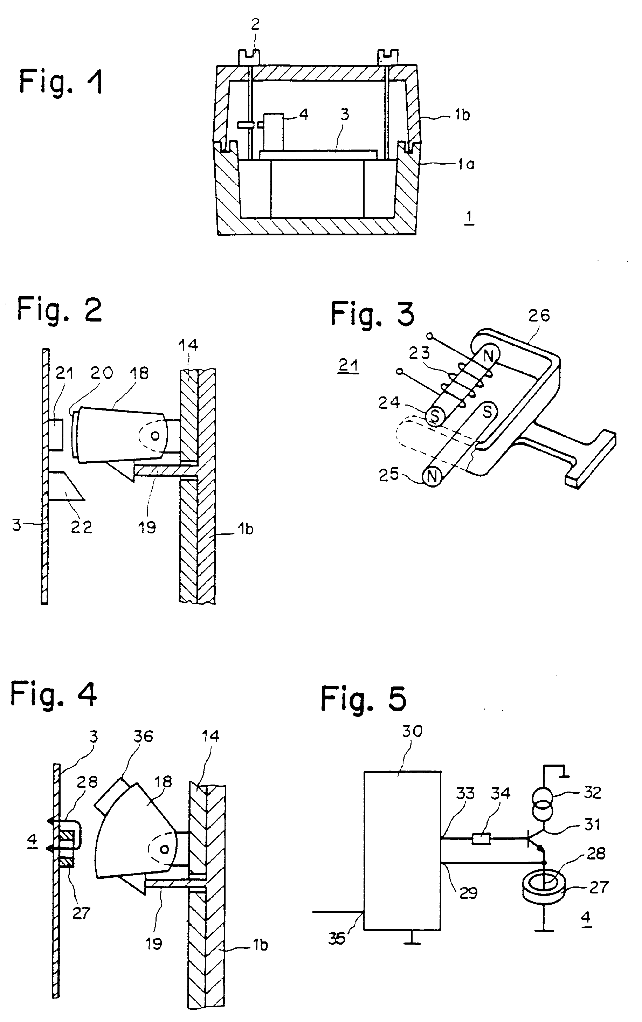

In der Fig. 1 bedeutet 1 ein Apparategehäuse mit einem Gehäuseunterteil 1a und einem Gehäuseoberteil 1b. Eine Verschlusseinrichtung 2, die beispielsweise eine Schraube ist, verschliesst das Gehäuseoberteil 1b mit dem Gehäuseunterteil 1a. Im Apparategehäuse 1 ist eine Leiterplatte 3 angeordnet, die mit einem Sensor 4 und mit weiteren hier nicht gezeichneten Komponenten bestückt ist. Der Sensor 4 ist derart ausgebildet, dass sein Zustand bei jeder Betätigung der Verschlusseinrichtung 2 verändert wird. Jede Betätigung der Verschlusseinrichtung 2 wird also als ein Ereignis im Sensor 4 abgespeichert. Der Sensor 4 ist dabei so ausgebildet, dass zum Abspeichern von mindestens einem solchen Ereignis keine Hilfsenergie notwendig ist. Der Zustand des Sensors 4 ist durch eine hier nicht gezeichnete Fernableseinrichtung erfassbar. Die Fernableseinrichtung kann dabei entweder direkt den Sensor 4 abfragen oder es ist eine Einrichtung, beispielsweise ein Mikrocomputer, zwischen dem Sensor 4 und der Fernableseeinrichtung angeordnet, die jedes aufgetretene Ereignis z.B. in einem unverlierbaren Speicher (NVRAM) speichert und von Zeit zu Zeit von der Fernableseeinrichtung abgefragt wird.

Es ist also mindestens ein an die Verschlusseinrichtung 2 gekoppelter Sensor 4 angeordnet, dessen Zustand beim Oeffnen bzw. beim Schliessen der Verschlusseinrichtung 2 veränderbar ist. Der Sensor 4 ist zur Speicherung dieser Zustandsänderung ausgebildet und es sind Mittel angeordnet, durch die der Zustand des Sensors 4 erfassbar ist und die an eine Fernableseeinrichtung anschliessbar sind.

Wird das Gehäuse 1 durch die Betätigung der Verschlusseinrichtung 2 geöffnet, so wird der Zustand des Sensors 4 verändert. Diese Zustandsänderung wird über die Fernableseeinrichtung festgestellt und entsprechende Massnahmen wie beispielsweise eine Kontrolle vor Ort können eingeleitet werden. Dadurch, dass der Sensor 4 keine Hilfsenergie benötigt, wird auch bei einer Oeffnung des Apparategehäuses 1 während eines Netzspannungsausfalles der Zustand des Sensors 4 verändert. Bei Wiederkehr der Netzspannung wird über die Fernablesung das Ereignis registriert.

Es lassen sich nicht nur Gehäuse 1 durch Sensoren 4 sichern, sondern auch Gehäuseteile wie beispielsweise Klemmendeckel.

Durch eine solche Einrichtung ist eine zuverlässige Ueberwachung von Apparaten möglich, die über die Fernableseeinrichtung mit einer Zentrale in Verbindung stehen und die normalerweise nicht oder nur in sehr grossen zeitlichen Abständen einer periodischen Kontrolle unterzogen werden.

Es ist vorteilhaft, die Verschlusseinrichtung 2 zusätzlich durch eine Plombe zu sichern, damit vor Ort jederzeit, auch ohne Zuhilfenahme der Fernableseeinrichtung, ein unbefugtes Oeffnen des Apparategehäuses 1 festgestellt werden kann.

In den folgenden Figuren sind gleiche oder gleichwirkende Teile mit gleichen Bezugszeichen bezeichnet.

In der Fig. 2 ist an einem Gehäuseteil 14, das Bestandteil des Gehäuseunterteiles 1a ist, ein drehbar belagertes Segment 18 angeordnet. Ein Stift 19, der Bestandteil des Gehäuseoberteiles 1b ist, durchdringt das Gehäuseteil 14 und hält das Segment 18 entgegen der Schwerkraft in einer ersten Lage fest. Am Kopf des Segmentes 18 ist ein magnetisierbares Element 20 angeordnet. Ein Schreib/Lesekopf 21 ist auf der Leiterplatte 3 so angeordnet, dass das Element 20 in seinem Wirkungsbereich ist. Ein Dauermagnet 22 ist im Schwenkbereich des Segmentes 18 und damit des Elementes 20 angeordnet. Der Schreib/Lesekopf 21 steht mit einem hier nicht gezeichneten Mikrocomputer in Verbindung und dieser wiederum mit einer Fernableseinrichtung.

Der Schreib/Lesekopf 21 beschreibt das Element 20 mit einer Information und liest diese anschliessend wieder. Ein solcher Schreib-Lese-Zyklus wird in regelmässigen Abständen durchgeführt. Wird das Gehäuseoberteil 1b abgenommen, d.h. wird das Apparategehäuse 1 (Fig. 1) geöffnet, so gibt der Stift 19 das Segment 18 frei. Das Segment 18 bewegt sich unter dem Einfluss der Schwerkraft oder einer Feder nach unten und gelangt in den Wirkungsbereich des Dauermagneten 22, der die Information auf dem Element 20 verändert. Beim nächsten Lesezyklus stellt der Mikrocomputer fest, dass das Segment 18 fehlt, dass also das Gehäuseoberteil 1b entfernt worden sein muss. Nach einem Netzspannungsausfall beginnt der Schreib/Lesekopf 21 bzw. der Mikrocomputer immer mit einem Lesezyklus. Wurde in der Zwischenzeit, d.h. im spannungslosen Zustand, das Gehäuseoberteil lb entfernt und wieder aufgesetzt, so ist nach einem solchen Vorgang die Information auf dem Element 20 durch den Dauermagneten 22 verändert. Der Mikrocomputer stellt also zuverlässig fest, dass in der Zwischenzeit das Gehäusoberteil 1b entfernt wurde.

Die Fig. 3 zeigt einen besonders einfach aufgebauten Schreib/Lesekopf 21 mit einer Spule 23 mit einem Weicheisenkern 24. Parallel dazu ist ein stabförmiger Dauermagnet 25 angeordnet. Ein U-förmiger Bügel 26, der die Funktion des Segmentes 18 (Fig. 2) und des magnetisierbaren Elementes 20 übernimmt und aus einem magnetisch halbharten Werkstoff besteht, ist drehbar gelagert angeordnet und umfasst mit seinen beiden Armen in einer ersten Stellung den Weicheisenkern 24 und in einer zweiten Stellung den Dauermagneten 25. Die Spule 23 ist an den oben erwähnten Mikrocomputer und dieser wiederum an die Fernableseeinrichtung angeschlossen.

Bei geschlossenem Apparategehäuse 1 (Fig. 1) hält der Stift 19 (Fig. 2) den Bügel 26 in der ersten Stellung fest. Der Weicheisenkern 24 und der Bügel 26 bilden einen geschlossenen magnetischen Kreis. Die Induktivität der Spule 23 ist gross. Der Mikrocomputer misst in regelmässigen Abständen die Induktivität der Spule 23. Der dabei fliessende Strom magnetisiert den Weicheisenkern 24 und den Bügel 26, und zwar umgekehrt zur Polarität des Dauermagneten 25. Wird das Apparategehäuse 1 geöffnet, bewegt sich der Bügel 26 in die zweite Stellung, beispielsweise unter dem Einfluss der Schwerkraft oder einer Feder. Der magnetische Kreis ist offen, die Induktivität der Spule 23 ist klein. Der Mikrocomputer und damit die Fernableseeinrichtung stellen fest, dass das Apparategehäuse 1 geöffnet wurde. In der zweiten Stellung wird der Bügel 26 vom Dauermagneten 25 in umgekehrter Richtung magnetisiert. Beim Verschliessen des Apparatehäuses bewegt sich der Bügel 26 wieder in die erste Stellung zurück. Der Bügel 26 ist jetzt umgekehrt magnetisiert. Bei der nächsten Messung magnetisiert der Strom in der Spule 23 den Bügel 26 wieder in der ursprünglichen Richtung. Der für die Ummagnetisierung notwendige Energieaufwand wird vom Mikrocomputer registriert. Damit ist es möglich, auch nach einem Spannungsausfall festzustellen, dass in der Zwischenzeit das Gehäuse geöffnet worden ist.

Es sind also ein magnetisch beschreibbarer Informationsträger, nämlich der Bügel 26, ein Schreib/Lesekopf 21 und ein Dauermagnet 25 angeordnet. Der Informationsträger ist in einer ersten Stellung vom Schreib/Lesekopf 21 lesbar und beschreibbar und in einer zweiten Stellung vom Dauermagneten 25 löschbar.

In den Fig. 4 und 5 ist ein Ringkern 27, wie er beispielsweise in Ringkernspeichern Verwendung findet, auf der Leiterplatte 3 angeordnet. Eine Wicklung um den Ringkern 27 ist auf einen einzigen Schreib/Lesedraht 28 reduziert, der durch den Ringkern 27 gezogen ist. Der Ringkern 27 und der Schreib/Lesedraht 28 bilden zusammen einen Sensor 4. Das eine Ende des Schreib/Lesedrahtes 28 ist mit einem Eingang 29 (Fig. 5) eines Mikrocomputers 30 und mit dem Emitter eines Transistors 31 und das andere Ende des Schreib/Lesedrahtes 28 ist mit der Masse verbunden. Der Eingang 29 des Mikrocomputers 30 ist ein Eingang mit einem integrierten Analog/Digital-Wandler. Die Grösse einer über dem Schreib/Lesedraht 28 auftretenden Spannung wird vom Analog/Digital-Wandler digitalisiert, d.h. in einen Zahlenwert umgewandelt, der vom Mikrocomputer 30 verarbeitet werden kann. Der Kollektor des Transistors 31 ist mit einer Stromquelle 32 verbunden. Ein Ausgang 33 des Mikrocomputers 30 führt über einen Widerstand 34 auf die Basis des Transistors 31. Ein Ausgang 35 des Mikrocomputers 30 ist mit einer hier nicht gezeichneten Fernableseeinrichtung verbunden.

Am Gehäuseteil 14 (Fig. 4) ist ein drehbar gelagertes Segment 18 angeordnet. Ein Stift 19, der Bestandteil des Gehäuseoberteiles 1b ist, durchdringt das Gehäuseteil 14 und hält das Segment 18 entgegen der Schwerkraft in einer ersten Lage fest. Am Kopf des Segmentes 18 ist ein Dauermagnet 36 angeordnet, der sich bei geschlossenem Gehäuseoberteil 1b oberhalb des Ringkernes 27 befindet und der in dieser ersten Stellung den Ringkern 27 nicht beeinflusst.

Impulse am Ausgang 33 des Mikrocomputers 30 schalten den Transistor 31 periodisch in Durchlassrichtung. Von der Stromquelle 32 fliessen somit periodisch stromimpulse durch den schreib/Lesedraht 28. Diese Stromimpulse magnetisieren den Ringkern 27 in einer ersten Richtung. Bei jedem Stromimpuls entsteht über dem Schreib/Lesedraht 28 ein Spannungsimpuls, dessen Grösse vom Mikrocomputer 30 gemessen wird und der klein ist, solange die Magnetisierungsrichtung des Ringkernes 27 nicht durch äussere Einflüsse gestört wird. Wird das Gehäuseoberteil 1b entfernt, so gibt der Stift 19 das Segment 18 frei. Das Segment 18 und damit der Dauermagnet 36 bewegen sich unter dem Einfluss der Schwerkraft oder einer Feder von der ersten Stellung in eine zweite Stellung, bei der der Dauermagnet 36 dem Ringkern 27 gegenübersteht. Der Dauermagnet 36 verändert dabei die Magnetisierungsrichtung des Ringkernes 27. Solange sich der Dauermagnet 36 in der zweiten Stellung befindet, sind die Spannungsimpulse gross. Wenn das Apparategehäuse 1 geschlossen wird und damit der Dauermagnet 36 wieder in die erste Stellung zurückbewegt wird, stellt der nächstfolgende Stromimpuls wieder die ursprüngliche Magnetisierungsrichtung her. Auch bei ausgefallener Netzspannung wird die Magnetisierungsrichtung des Ringkernes 27 beim Entfernen des Gehäuseoberteiles 1b verändert. Diese Veränderung bleibt gespeichert, bis bei der Wiederkehr der Netzspannung durch den ersten Stromimpuls wieder die ursprüngliche Magnetisierungsrichtung hergestellt wird. Der Ausgang 35 des Mikrocomputers 30 wird periodisch von der Fernableseeinrichtung auf den Zustand des Ringkernes 27 abgefragt.

Diese Anordung ist besonders vorteilhaft bei engen Platzverhältnissen, weil der Ringkern 27 sehr klein dimensioniert werden kann und damit auch der für die Ummagnetisierung notwendige Dauermagnet 36.

Die Sensoren nach den Fig. 2 und 3 und insbesondere nach den Fig. 4 und 5 sind einfach aufgebaut. Der Aufwand für die notwendigen Schaltkreise für den Betrieb des Schreib/Lesekopfes 21 der Spule 25 oder des Ringkernes 27 ist bei modernen Geräten, die über kundenspezifische integrierte Schaltungen verfügen, klein, da die Schaltkreise ohne Mehraufwand integriert werden können. Solche Sensoren ermöglichen eine zuverlässige Ueberwachung von Apparategehäusen 1 auch bei ausgefallener Netzspannung. Es ist dabei kaum möglich, nach dem Oeffnen des Apparatehäuses 1 das Element 20, den Bügel 26 oder den Ringkern 27 magnetisch so zu beeinflussen, dass der Vorgang nach Wiederkehr der Netzspannung unbemerkt bleibt. Die Sicherheit kann weiter erhöht werden durch die Anordnung von mehreren Sensoren oder dadurch, dass pro Sensor nicht nur ein Bit, sondern mehrere Bit in der Form eines ständig wechselnden Codes gespeichert sind.

Die beschriebene Einrichtung zur Ueberwachung von Apparategehäusen 1 ist speziell für den Einsatz in Elektrizitätszählern geeignet, die über eine Fernablesung verfügen. Ist ein solcher Elektrizitätszähler einerseits mit einem Sensor 4 ausgerüstet und andererseits mit einer herkömmlichen Plombierung versehen, so kann der Elektrizitätszähler jederzeit sowohl über die Fernablesung als auch vor Ort durch die Kontrolle der Plombierung darauf überprüft werden, ob jemand unberechtigterweise das Apparategehäuse 1 geöffnet hat.

## Patentansprüche

1. Einrichtung zur Überwachung eines Apparategehäuses (1), das aus mindestens zwei durch eine Verschlußeinrichtung (2) miteinander verbundenen Gehäuseteilen (1a, 1b; 14) besteht, mit einem an die Verschlußeinrichtung (2) oder an mindestens eines der Gehäuseteile (1a, 1b; 14) gekoppelten Sensor (4), dessen Zustand sich beim Öffnen oder Schließen der Verschlußeinrichtung (2) oder des Apparategehäuses (1) verändert und der durch eine Fernableseeinrichtung ablesbare Mittel zur Speicherung dieser Zustandsänderung aufweist,
**dadurch gekennzeichnet,**
daß der Sensor (4) einen magnetisch beschreibbaren Informationsträger (20; 26; 27) und einen Dauermagneten (22; 25; 36) aufweist, welche derart angeordnet sind, daß sich ihre gegenseitige Lage beim Öffnen oder Schließen der Verschlußeinrichtung (2) oder des Apparategehäuses (1) dermaßen ändert, daß sich die Information auf dem Informationsträger (20; 26; 27) ändert.

2. Einrichtung nach Anspruch 1,
**dadurch gekennzeichnet,**
daß der Sensor (4) zudem einen Schreib/Lesekopf (21; 23, 24) aufweist und daß der Informationsträger (20;26) in einer ersten Stellung vom Schreib/Lesekopf (21; 23, 24) Lesbar und beschreibbar und in einer zweiten Stellung vom Dauermagneten (22; 25) Löschbar ist.

3. Einrichtung nach Anspruch 1,
**dadurch gekennzeichnet,**
daß der Informationsträger einen Ringkern (27) und einen Schreib/Lesedraht (28) aufweist, der durch den Ringkern (27) gezogen ist, und daß der Dauermagnet (36) derart angeordnet ist, daß er sich beim Öffnen des Apparategehäuses (1) oder der Verschlußeinrichtung (2) von einer ersten Stellung in eine zweite Stellung bewegt und dabei die Magnetisierungsrichtung des Ringkerns (27) verändert.

## Claims

1. A device for monitoring an apparatus housing (1) which comprises at least two housing portions (1a, 1b; 14) which are connected together by a closure means (2), comprising a sensor (4) which is coupled to the closure means (2) or to at least one of the housing portions (1a, 1b; 14) and whose condition changes upon opening or closing of the closure means (2) or the apparatus housing (1) and which has means for storing that change in condition, which means can be read off by a remote reading means, characterised in that the sensor (4) has a magnetically writable information carrier (20; 26; 27) and a permanent magnet (22; 25; 36) which are so arranged that their mutual position changes upon opening or closing of the closure means (2) or the apparatus housing (1) in such a way that the information on the information carrier (20; 26; 27) changes.

2. A device according to claim 1 characterised in that the sensor (4) also has a write/read head (21; 23, 24) and that the information carrier (20; 26) is readable and writable in a first position of the write/read head (21; 23, 24) and is erasable in a second position by the permanent magnet (22; 25).

3. A device according to claim 1 characterised in that the information carrier has a ring core (27) and a write/read wire (28) which is passed through the ring core (27), and that the permanent magnet (26) is so arranged that upon opening of the apparatus housing (1) or the closure means (2) it moves from a first position into a second position and in so doing changes the direction of magnetisation of the ring core (27).

## Revendications

1. Dispositif pour surveiller un boîtier d'appareil (1), qui se compose d'au moins deux parties de boîtier (1a,1b ; 14) relieés entre elles par un dispositif d'obturation (2), avec un détecteur (4) accouplé au dispositif d'obturation (2) ou à au moins une des parties de boîtier (1a,1b ; 14), dont l'état change lors d'une ouverture ou d'une fermeture du dispositif d'obturation (2) ou du boîtier d'appareil (1) et qui comporte des moyens, pouvant être lus par un dispositif de lecture à distance pour une mémorisation de ce changement d'état, caractérisé en ce que le détecteur (4) comporte un support d'informations (20 ; 26 ; 27) pouvant être écrit magnétiquement et un aimant permanent (22 ; 25 ; 36), qui sont disposés de telle sorte que leur disposition mutuelle soit modifiée, lors d'une ouverture ou d'une fermeture du dispositif d'obturation (2) ou du boîtier d'appareil (1) que l'information se trouvant sur le support d'information (20 ; 26 ; 27) est modifiée.

2. Dispositif selon la revendication 1, caractérisé en ce que le détecteur (4) comporte en outre une tête d'écriture/lecture (21 ; 23 ; 24) et en ce que le support d'information (20 ; 36) peut être lu et écrit dans une première position par la tête d'écriture/lecture (21 ; 23, 24) et peut être effacé dans une seconde position par l'aimant permanent (22 ; 25).

3. Dispositif selon la revendication 1, caractérisé en ce que le support d'information comporte un noyau annulaire (27) et un fil d'écriture/lecture (28), qui est tiré par le noyau annulaire (27), et en ce que l'aimant permanent (36) est disposé de telle sorte que, lors de l'ouverture du boîtier d'appareil (1) ou du dispositif d'obturation (2), il se déplace d'une première position dans une seconde position et modifie ainsi le sens de magnétisation du noyau annulaire (27).
